# DEMANDE DE BREVET EUROPEEN

(11) **EP 2 148 443 A1**
(43) Date de publication de la demande: **27.01.2010**
(21) Numéro de dépôt: 08161218.6
(22) Date de dépôt: 25.07.2008
(51) Int. Cl.: H03K 19/00

(54) **Dispositif de connexion pour circuit intégré**

(71) Demandeur: EM Microelectronic-Marin SA, 2074 Marin (CH)
(72) Inventeur: Théoduloz, Yves, 1400 Yverdon (CH); Jaeggi, Hugo, 2046 Fontaines (CH); Plavec, Lubomir, 262 13 Necin (CZ)
(74) Mandataire: Couillard, Yann Luc Raymond

(57) **Abrégé**

Le dispositif de connexion (1) d'un circuit intégré permet de connecter un composant externe. Le circuit intégré est alimenté par une tension d'alimentation (V_{DD}) et une partie du circuit fonctionnant à l'aide d'au moins une tension régulée interne (V_{REG}). Le dispositif de connexion comprend deux transistors actifs (N1, P1) de conductivité différente montés en série entre la tension d'alimentation (V_{DD}) et la masse (V_{SS}). Les drains de ces deux transistors actifs (N1, P1) sont reliés ensemble de sorte à former une plage de contact externe (2). Les grilles de ces transistors actifs sont commandées par des signaux de tension ayant une même amplitude (V_{esd}). Le dispositif de connexion comprend en outre des moyens de commutation (3) permettant de modifier les signaux de commande (V_{esd}) appliqués sur les grilles des transistors actifs, sans dépasser la plus grande des tensions entre la tension d'alimentation (V_{DD}) ou la tension régulée interne (V_{REG}). Ceci permet d'adapter le domaine de tension dudit circuit intégré à un composant externe connecté à la plage de contact externe (2).

## Description

L'invention concerne un dispositif de connexion d'un circuit intégré pour connecter un composant externe. Le circuit intégré est alimenté par une tension d'alimentation et une partie du circuit fonctionne à l'aide d'au moins une tension régulée interne. Le dispositif de connexion comprend deux transistors actifs de conductivité différente montés en série entre la tension d'alimentation et la masse. Les drains de ces deux transistors actifs sont reliés ensemble de sorte à former une plage de contact externe, et les grilles de ces transistors actifs sont commandées par des signaux de tension ayant une même amplitude.

### ARRIERE PLAN TECHNOLOGIQUE

Il est connu de l'art antérieur des dispositifs de connexion pour circuit intégré. En effet, les circuits intégrés sont généralement équipés de dispositifs de connexion permettant la connexion de composants externes ainsi que la communication entre cet élément externe et ledit circuit intégré.

Ces dispositifs de connexion consistent en deux transistors actifs MOS (PMOS et NMOS) montés en inverseur de sorte qu'ils forment alors un buffer. Ainsi les grilles de ces deux transistors, formant l'entrée de l'inverseur, sont connectées à la tension d'alimentation et à la masse du circuit intégré. Les drains des transistors, formant la sortie de l'inverseur, représentent la plage de contact externe sur laquelle se connectera un composant externe.

Un problème de ce dispositif de connexion est qu'il ne peut être connecté que des composants dont le niveau de tension est inférieur ou égal à la tension appliquée à la grille des transistors MOS. En d'autres termes, la tension de fonctionnement des composants externes ne doit pas être supérieure à la tension d'alimentation du circuit intégré. Or, le but dans ce genre de dispositif de connexion est que le transistor PMOS du buffer soit toujours non conducteur tant que la tension appliquée sur les drains est inférieur à la tension appliquée sur les grilles.

En effet, le buffer est toujours non conducteur tant que la tension du composant externe qui est connecté est plus faible ou égale aux tensions de grille qui est généralement proche de la tension d'alimentation. Or, en connectant un composant externe dont la tension de fonctionnement est supérieure aux tensions de grille du transistor PMOS, le buffer risque de ne plus être non conducteur.

La conductivité du buffer peut provoquer une augmentation du courant dans le transistor PMOS de l'inverseur. Ceci peut conduire à une injection de courant depuis le composant externe dans la tension d'alimentation du circuit intégré. Cette injection de courant introduit alors du bruit sur la tension d'alimentation et de la surconsommation.

D'autre part, une tendance actuelle en électronique est de baisser les tensions d'alimentation des circuits. Or cette tendance n'est pas compatible avec le fait d'avoir les tensions de fonctionnement des composants externes plus faible ou égale à la tension de grille des transistors MOS.

### RESUME DE L'INVENTION

Un des buts de la présente invention est de fournir un dispositif de connexion pour circuit intégré qui pallie les inconvénients susmentionnés de l'art antérieur.

A cet effet, l'invention concerne le dispositif de connexion conforme au préambule ci-dessus et **caractérisé en ce que** le dispositif de connexion comprend en outre des moyens de commutation permettant de modifier le niveau d'amplitude des signaux de tension appliqués sur les grilles des transistors actifs, sans dépasser la plus grande des tensions entre la tension d'alimentation ou la tension régulée interne, afin d'adapter le domaine de tension dudit circuit intégré à un composant externe connecté à la plage de contact externe.

Grâce à cette caractéristique, le dispositif permet de connecter audit circuit intégré, par l'intermédiaire de la plage de contact externe, des composants externes fonctionnant à des tensions de fonctionnement différentes de la tension d'alimentation et notamment des composants externes dont la tension de fonctionnement est supérieure à la tension d'alimentation du circuit intégré. Cela du fait que ce n'est pas forcément la tension d'alimentation qui est appliquée aux grilles des transistors MOS.

Des modes de réalisation avantageux du dispositif de connexion font l'objet des revendications dépendantes 2 à 10.

Un avantage de la présente invention est que ce dispositif permet une protection améliorée du circuit intégré. En effet, en étant capable de fonctionner à différents niveaux de tensions, le dispositif selon la présente invention permet de commuter la tension de grille des transistors MOS d'une valeur à l'autre. Ainsi, dans le cas où la tension d'alimentation et la tension du composant connecté sont très proches, le fait de pouvoir commuter sur un domaine de tension différent permet d'éviter les problèmes de bruit dus à la conductivité du buffer du circuit intégré.

Un autre avantage au dispositif de la présente invention est de permettre une flexibilité dans l'utilisation du circuit intégré. En effet, la présente invention permet de connecter des composants de différents niveaux de tensions à un circuit intégré. Cette flexibilité devient très intéressante dans le cas où l'on désire utiliser une tension d'alimentation réduite. Effectivement, dans l'art antérieur, la tension d'alimentation constitue une limite supérieure pour la tension de fonctionnement du composant externe connecté. En cas de dépassement de cette limite, il y a l'apparition de bruit sur la tension d'alimentation venant de l'injection de courant. On comprendra donc que le dispositif selon la présente invention permet d'utiliser une tension d'alimentation réduite sans pour autant devoir limiter les niveaux de tension des composants connectés.

### BREVE DESCRIPTION DES FIGURES

Les buts, avantages et caractéristiques du dispositif de connexion apparaîtront plus clairement dans la description détaillée suivante d'au moins une forme de réalisation de l'invention donnée uniquement à titre d'exemple non limitatif et illustrée par les dessins annexés sur lesquels :
- la figure 1 représente de manière schématique le dispositif de connexion selon la présente invention;
- la figure 2 représente de manière schématique le dispositif de décalage de tension utilisé; et
- la figure 3 représente de manière schématique le dispositif de connexion selon un mode de réalisation préférentiel.

### DESCRIPTION DETAILLEE DE L'INVENTION

Dans la description suivante, toutes les parties du circuit intégré qui sont bien connues d'un homme du métier dans ce domaine technique ne seront expliquées que de manière simplifiée.

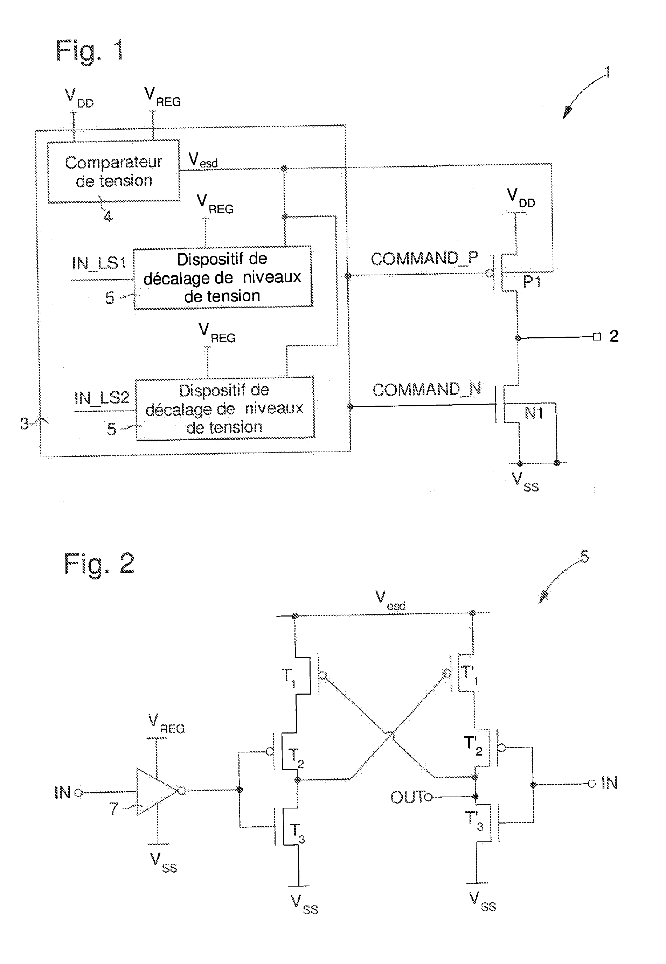

La figure 1 représente de manière schématique le dispositif de connexion 1 selon la présente invention. Ce dispositif 1 comprend un buffer constitué de deux transistors actifs. Ce buffer comprend plus précisément un transistor P1 et un transistor N1 montés en série. Ainsi, les drains des deux transistors N1, P1 sont reliés ensemble alors que la source du transistor P1 est reliée à la tension d'alimentation V_{DD} et que la source et le caisson du transistor N1 est reliée à la masse V_{SS}. Les drains des deux transistors sont également reliés à la plage de contact externe 2 où peut être connecté un composant externe. Les grilles de ces transistors N1, P1 sont reliées au même potentiel, alors que le caisson du transistor P1 est polarisé à une tension correspondant à la valeur maximum de l'amplitude des signaux de tensions commandant les transistors N1 et P1.

Cet agencement permet ainsi de garantir que le niveau logique « 1 » est égal à V_{DD} lorsque la tension d'alimentation V_{DD} est connectée à la source du transistor P1. De plus, cet agencement permet de garantir la non-conductivité du buffer lorsque la tension appliquée sur la plage de contact externe 2 est inférieure ou égale au potentiel appliqué sur les grilles des transistors N1 et P1. Or, comme dit précédemment, si la tension appliquée à la plage de contact externe 2 est supérieure à la tension de grille alors le buffer risque de ne plus être non conducteur. Il faut néanmoins comprendre que la tension du composant externe se branchant sur la plage de contact externe 2 ne doit jamais être supérieur à la tension appliquée aux grilles des transistors N1 et P1.

C'est pourquoi la présente invention comprend en outre des moyens permettant d'appliquer à la plage de contact externe 2 une tension supérieure à V_{DD} sans rendre le buffer conducteur. Pour cela, le présent dispositif de connexion 1 comprend des moyens de commutation 3 permettant de modifier la valeur du potentiel appliqué aux grilles des transistors N1 et P1 afin de l'adapter à la tension appliquée sur la plage de contact externe 2. Ces moyens de commutation 3 comprennent des moyens de sélection 4 et des moyens de transformation 5.

Néanmoins, pour modifier la valeur du potentiel appliqué aux grilles des transistors N1 et P1, il faut pouvoir générer les différentes tensions que l'on veut appliquer. C'est pourquoi le circuit intégré est pourvu de moyens permettant la génération de ces tensions différentes, cela peut inclure divers moyens tels que par exemple un ou plusieurs convertisseurs DC-DC. Bien entendu, ces tensions peuvent servir pour d'autres fonctions du circuit intégré telles que l'alimentation des moyens de commutation 3.

Dans un mode de réalisation préférentiel, le transistor P1 est un transistor de conductivité P du type PMOS et le transistor N1 est un transistor de conductivité N du type NMOS. Le circuit est alimenté par une tension d'alimentation V_{DD} et comprend des moyens permettant de générer une tension interne régulée V_{REG}. Ainsi, pour modifier la plage de tension des plages de contact externes 2 du circuit intégré, les moyens de commutation 3 vont modifier le potentiel des grilles des transistors actifs N1, P1 avec l'une ou l'autre des deux tensions V_{DD} ou V_{REG}. Cela permet ainsi d'avoir plusieurs domaines de tension possibles au niveau du buffer. Préférentiellement, c'est la plus élevée des deux tensions, qui est sélectionnée. Cela permet ainsi d'avoir toujours le domaine de tension le plus grand et donc un plus grand choix de tension de circuit externe à connecter.

Les moyens de sélection 4 se présentent sous la forme d'un comparateur de tension 4 qui va comparer V_{DD} et V_{REG} afin de sélectionner la tension la plus élevée. Le comparateur 4 délivre alors, en sortie, une tension V_{esd} de valeur égale à la tension la plus élevée entre V_{REG} et V_{DD}. Cette tension V_{esd} est alors transmise au moyen de transformation 5 ainsi qu'au caisson du transistor P1 afin de commander ledit buffer. Les moyens de transformation 5 servent à modifier le niveau de tension des signaux d'entrée IN_LS1 et IN_LS2 pour fournir des signaux de commande des transistors COMMAND_N et COMMAND_P appliqués sur les grilles des transistors N1, P1 en les mettant à la tension V_{esd}. Bien entendu, On pourra prévoir que la sélection de la tension V_{esd} se fasse automatiquement en fonction de la tension du composant externe appliquée à la plage de contact externe 2. Ainsi, le comparateur de tension 4 sélectionnant directement la tension qui est supérieure à celle du composant externe. En effet, cela permet alors au circuit intégré de s'adapter automatiquement à la tension du composant externe et donc d'éviter au buffer de devenir conducteur.

Les moyens de transformation 5 se présentent sous la forme de dispositif de décalage du niveau de tension (Level shifter en terminologie anglo-saxonne) qui transforme les signaux d'entrée de commande venant du circuit intégré travaillant sous la tension V_{REG} pour adapter leur niveau de tension en sortie vers la tension V_{esd}.

Ces dispositifs de décalage du niveau de tension 5, représentés sur la figure 2, comprennent une entrée IN donnant sur un inverseur 7 alimenté par V_{REG} et un système à transistor. Ce système est articulé en deux branches symétriques comprenant chacune trois transistors actifs. Chaque branche comprend ainsi deux transistors de conductivité P appelés T1, T2 pour la première branche et T'1, T'2 pour la seconde branche ainsi qu'un transistor de conductivité N appelé T3 pour la première branche et T'3 pour la seconde branche. Chaque transistor T3, T'3 est respectivement monté en série avec un transistor T2, T'2, la source des transistors T3, T'3 étant connectée à la masse V_{SS}. Les transistors T1, T'1 sont montés en série avec les transistors T2, T'2 et alimentés par V_{esd} au niveau de leur source. Les grilles des transistors T2 et T3 sont reliées ensemble à la sortie de l'inverseur 7. Les grilles des transistors T'2 et T'3 sont reliées ensemble à l'entrée IN de l'inverseur 7. Les drains des transistors T2 et T3 sont reliés ensemble à la grille du transistor T'1. Les drains des transistors T'2 et T'3 sont reliés ensemble à la grille du transistor T1, ces drains formant également la sortie OUT du dispositif de décalage du niveau de tension.

Lors du fonctionnement de ce circuit, si l'entrée IN de l'inverseur est à un niveau logique « 1 », la sortie de l'inverseur est donc à un niveau logique « 0 ». L'application de ce niveau logique « 0 » sur la grille des transistors T2 et T3 provoque le passage du transistor T2 en mode conducteur et du transistor T3 en mode non conducteur. Par ailleurs, l'application du signal d'entrée de l'inverseur sur la grille des transistors T'2 et T'3 provoque le passage du transistor T'2 en mode non conducteur et du transistor T'3 en mode conducteur. Du fait que le transistor T'3 est conducteur et que les drains de T'2 et T'3 soient reliés à la grille du transistor T1, cela permet de connecter ladite grille du transistor T1 à la masse V_{SS}, rendant ce dernier conducteur. Etant donné que les transistors T1 et T2 sont conducteurs, la tension V_{esd} traverse ces transistors. Le drain du transistor T2 étant relié à la grille du transistor T'1, la tension V_{esd} est alors appliquée sur la grille du transistor T1. Le transistor T1 devient alors non conducteur. La sortie OUT du dispositif de décalage du niveau de tension, qui est le point de connexion des drains des transistors T'2 et T'3, est alors la masse V_{SS}. Inversement, lorsque l'entrée IN de l'inverseur est à un niveau logique « 0 », les transistors T1, T2 et T'3 deviennent non conducteurs alors que les transistors T3, T'1 et T'2 deviennent conducteurs. Cela permet alors à la sortie OUT du dispositif de décalage de tension d'être à V_{esd}.

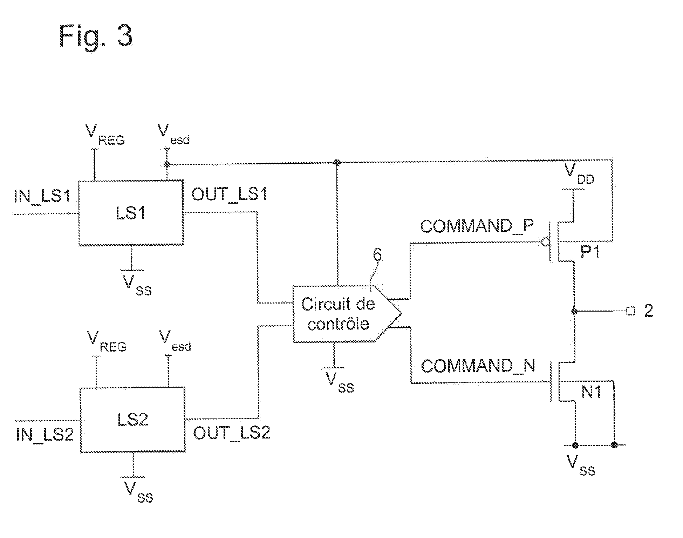

Sur le schéma de la figure 3 sont représentés deux dispositifs de décalage du niveau de tension LS1 et LS2. Le premier LS1 de ces dispositifs est celui qui décale les niveaux de tension de signaux de contrôle desdits transistors N1 et P1. En entrée de ce dispositif LS1 est appliqué un signal IN_LS1 pour la commande des transistors. Le second LS2 de ces dispositifs est utilisé pour mettre ledit buffer de sortie en mode haute impédance. Ce mode se caractérise par le fait que le niveau logique de ladite plage de contact externe 2 n'est ni au niveau logique « 1 » ni au niveau logique « 0 ». Cet état permet alors de ne pas créer de perturbation aux autres bornes du circuit intégré. Ce dispositif LS2 reçoit en entrée un signal IN_LS2 de commande de mise en mode haute impédance

Les signaux de sortie OUT_LS1 et OUT_LS2, sous la tension V_{esd}, sont envoyés sur un circuit de contrôle 6. Ce circuit de contrôle 6 se charge d'appliquer les signaux de commande COMMAND_N et COMMAND_P aux dites grilles des transistors P1 et N1 afin de les rendre conducteurs ou non ou en mode haute impédance.

Ce circuit de contrôle 6 comprend en outre des moyens pour appliquer les signaux de commande sur les grilles sans chevauchement. Pratiquement, le circuit de contrôle 6 rend d'abord un des transistors N1 ou P1 non conducteur avant de rendre l'autre conducteur. Cela de sorte à ce que les deux transistors ne soient pas conducteurs en même temps.

Bien évidemment, il peut être prévu certains agencements préférentiels tels que le fait que V_{REG} soit plus élevée que V_{DD}. Cet agencement permet entre autre de diminuer la tension d'alimentation V_{DD} tout en gardant la possibilité de connecter des composants externes dont la tension est supérieure à V_{DD} mais inférieure à V_{REG}.

Dans un autre mode de réalisation, il est prévu que le circuit intégré puisse générer un nombre de tensions internes régulées supérieur à deux. Cette multiplicité permet un réglage plus fin de la tension appliquée au transistor N1, P1 en fonction de la tension du composant externe. De plus, cela permet d'avoir un plus grand nombre de domaines de tensions possibles pour le buffer augmentant ainsi la flexibilité du circuit intégré.

De plus, on peut également prévoir que la sélection de la tension appliquée aux grilles de transistors ne soit pas faite par un détecteur de tension, mais par un sélecteur manuel.

On comprendra que diverses modifications et/ou améliorations et/ou combinaisons évidentes pour l'homme du métier peuvent être apportées aux différents modes de réalisation de l'invention exposés ci-dessus sans sortir du cadre de l'invention défini par les revendications annexées.

## Revendications

1. Dispositif de connexion (1) d'un circuit intégré pour connecter un composant externe, ledit circuit intégré étant alimenté par une tension d'alimentation (V_{DD}) et une partie du circuit fonctionnant à l'aide d'au moins une tension régulée interne (V_{REG}), ledit dispositif de connexion comprenant deux transistors actifs (N1, P1) de conductivité différente montés en série entre la tension d'alimentation (V_{DD}) et la masse (V_{SS}), les drains de ces deux transistors actifs (N1, P1) étant reliés ensemble de sorte à former une plage de contact externe (2), les grilles de ces transistors actifs étant commandées par des signaux de tension ayant une même amplitude (V_{esd}), **caractérisé en ce que** le dispositif de connexion comprend en outre des moyens de commutation (3) permettant de modifier le niveau d'amplitude des signaux de tension (V_{esd}) appliqués sur les grilles des transistors actifs, sans dépasser la plus grande des tensions entre la tension d'alimentation (V_{DD}) ou la tension régulée interne (V_{REG}), afin d'adapter le domaine de tension dudit circuit intégré à un composant externe connecté à la plage de contact externe (2).

2. Dispositif de connexion selon la revendication 1, **caractérisé en ce qu'**un premier transistor actif (N1) est du type NMOS et un second transistor actif (P1) est du type PMOS.

3. Dispositif de connexion selon les revendications 1 ou 2, **caractérisé en ce que** les moyens de commutation comprennent des moyens de sélection (4) pour sélectionner le niveau d'amplitude des signaux de tension (V_{esd}) entre la tension d'alimentation (V_{DD}) et la tension régulée interne (V_{REG}), à appliquer aux grilles desdits transistors actifs (N1, P1).

4. Dispositif de connexion selon la revendication 3, **caractérisé en ce que** les moyens de commutation comprennent en outre des moyens de transformation (5) pour adapter le niveau d'amplitude des signaux de tension pour commander les transistors avec la tension sélectionnée (V_{esd}).

5. Dispositif de connexion selon la revendication 1, **caractérisé en ce que** ledit dispositif de connexion comprend un dispositif de décalage du niveau de tension (LS1), recevant en entrée un premier signal de commande de grille des transistors (IN_LS1) qui fonctionne sous la tension interne régulée (V_{REG}), et fournissant en sortie un premier signal de sortie (OUT_LS1) à un circuit de contrôle (6) qui va traiter ce premier signal de sortie et appliquer aux transistors (N1, P1) les signaux de commandes (COMMAND_P, COMMAND_N) travaillant sous la tension sélectionnée (V_{esd}).

6. Dispositif de connexion selon la revendication 5, **caractérisé en ce que** ledit dispositif de connexion comprend un second dispositif de décalage du niveau de tension (LS2), recevant en entrée un second signal de commande de grille des transistors (IN_LS2) qui fonctionne sous la tension interne régulée (V_{REG}), et fournissant en sortie un second signal de sortie (OUT_LS2) au circuit de contrôle (6) qui va traiter ce second signal de sortie afin d'appliquer aux transistors (N1, P1) les signaux de commandes (COMMAND_P, COMMAND_N) pour mettre lesdits transistors en mode haute impédance.

7. Dispositif de connexion selon les revendications 5 ou 6, **caractérisé en ce que** ledit circuit de contrôle (6) permet de réaliser des ouvertures et des fermetures des transistors actifs (N1, P1) sans chevauchement.

8. Dispositif de connexion selon la revendication 3, **caractérisé en ce que** la sélection du niveau d'amplitude des signaux de tension (V_{esd}) entre la tension d'alimentation (V_{DD}) et la tension régulée interne (V_{REG}) est manuelle.

9. Dispositif de connexion selon la revendication 3, **caractérisé en ce que** la sélection du niveau d'amplitude des signaux de tension (V_{esd}) entre la tension d'alimentation (V_{DD}) et la tension régulée interne (V_{REG}) est automatique.

10. Dispositif de connexion selon la revendication 2, **caractérisé en ce que** le transistor PMOS (P1) comprend un caisson, qui est polarisé à une tension correspondant à la valeur maximum de l'amplitude des signaux de tension (V_{esd}).
